# EUROPEAN PATENT APPLICATION

(11) **EP 4 793 543 A1**
(43) Date of publication of application: **19.08.2026**
(21) Application number: 25178035.9
(22) Date of filing: 21.05.2025
(51) Int. Cl.: F23G 5/027, F23G 5/10, F23G 5/24, F23G 5/44, F23G 7/10

(54) **PLASMA ENERGIZATION EQUIPMENT**

(30) Priority: 14.02.2025 TW 114105608
(71) Applicant: Ke, Shih-Yuan, Chia Yi Hsien (TW)
(72) Inventor: Ke, Shih-Yuan, Chia Yi Hsien (TW)
(74) Representative: Rowlands, Stuart Michael

(57) **Abstract**

A plasma energization equipment is adapted for solving the problem of exhaust gas emissions within the conventional processing equipment. The equipment includes a furnace body, a heating module and a gas flow guiding device. The furnace body has an internal processing space and a gas collection channel. The heating module is arranged on the furnace body. The gas flow guiding device is arranged in the internal processing space. The gas flow guiding device has a first tube and a second tube. The first and second tubes each have a hollow internal space and are respectively provided with multiple first through holes and multiple second through holes. The first tube is sleeved over the second tube, allowing gas to flow from the internal processing space through the multiple first through-holes, the multiple second through-holes, the hollow space inside the first tube and the hollow space inside the second tube, and subsequently into the gas collection channel. Through said configuration of this invention, the equipment effectively facilitates the discharge of exhaust gas from the furnace body.

## Description

### BACKGROUND OF THE INVENTION

The present invention relates to a waste treatment technique and, more particularly, to a plasma energization equipment.

A general treating method for treating waste, including garbage, agricultural waste, medical waste, and industrial waste, includes incinerating the wastes in a treatment equipment. However, tar contained in waste or biomass waste will emerge together with the gases generated from carbonization, causing pollution. Even if the gas generated after carbonization of the waste is controlled within the treatment equipment, the tar will block the valves, pipes, and devices of the treatment equipment, causing corrosion.

Applicant's Taiwan Patent No. TW I785445B entitled "A WASTE TREATMENT INCINERATOR AND TREATMENT EQUIPMENT INCLUDING THE SAME" discloses a treatment equipment comprises a waste treatment incinerator, a heat exchange system, and a purification module. The heat exchange system includes a first heat exchange module connected to an exhaust pipe of a furnace of the waste treatment incinerator and a reservoir connected to the first heat exchange module. The purification module includes a gas inlet and a gas outlet. The gas inlet intercommunicates with the first heat exchange module. A sprinkling area is disposed between the gas inlet and the gas outlet. The treatment equipment generally utilizes multiple heat exchange systems to significantly lower the temperature of the gas discharged from the waste treatment incinerator. Then, the gas can be sent into the purification module for removing the harmful substances from the gas. A non-polluting gas mixture containing carbon monoxide and hydrogen is discharged. However, the treatment equipment is bulky.

To solve the problem of Taiwan Patent No. TW I785445B, Applicant's Taiwan Patent Application No. 112130693 entitled "WASTE TREATMENT EQUIPMENT" discloses a furnace including a tank for receiving waste. The tank includes an opening intercommunicating with a treatment space of the furnace. The processing space is provided with a stockpiling area, a material-awaiting area, an oxidation area, a charcoal slag layer area, and an ash accumulation area disposed from top to bottom in sequence. The charcoal slag layer area includes an exhaust gas collection member for collecting exhaust gas generated during heating of the waste in the furnace. The exhaust gas current flows through the charcoal slag layer area to proceed with preliminary filtration. The exhaust gas collection member is used to collect the exhaust gas after the preliminary filtration. However, in the charcoal slag layer area, the slag or other material/substances may be piled or squeezed to form dense and air-impermeable areas, such that the exhaust gas cannot pass through the charcoal slag layer area and, thus, cannot be collected by the exhaust gas collection member, resulting in accumulation of exhaust gas. Furthermore, the flammable gas (such as hydrogen) in the exhaust gas may backdraft when in an excessively high concentration.

### BRIEF SUMMARY OF THE INVENTION

To solve the above problem, an objective of the present invention is to provide a plasma energization equipment which can assist in discharge of exhaust gas.

Another objective of the present invention is to provide a plasma energization equipment which can prevent formation of dense and air-impermeable areas in the materials in the equipment.

When the terms "front", "rear", "left", "right", "up", "down", "top", "bottom", "inner", "outer", "side", and similar terms are used herein, it should be understood that these terms have reference only to the structure shown in the drawings as it would appear to a person viewing the drawings and are utilized only to facilitate describing the invention, rather than restricting the invention.

As used herein, the term "one" or "an" for describing the number of the elements and members of the present invention is used for convenience, provides the general meaning of the scope of the present invention, and should be interpreted to include one or at least one. Furthermore, unless explicitly indicated otherwise, the concept of a single component also includes the case of plural components.

When the terms "first", "second" ... and "nth", and similar terms are used herein, it should be understood that these terms are mainly used to provide descriptions to distinguish different components or features (such as the features of the elements, directions, steps, etc.), rather than representing the maximum or minimum quantity of the components or features of a corresponding subject or method nor restricting the sequences.

As used herein, the term "coupling", "join", "assembly", "installation" , "disposition" or similar terms is used to include separation of connected members without destroying the members after connection or inseparable connection of the members after connection. A person having ordinary skill in the art would be able to select according to desired demands in the material or assembly of the members to be connected.

A plasma energization equipment according to the present invention comprises a furnace, a heating module, and a gas flow guiding device. The furnace includes an internal processing space and a gas collection channel intercommunicating with the internal processing space. The heating module is disposed in the furnace to heat the internal processing space. The gas flow guiding device is disposed in the internal processing space and includes a first tube and a second tube. Each of the first tube and the second tube extends axially and is a hollow casing having a space therein. The first tube includes multiple first through holes disposed in a sidewall of the first tube. The second tube includes multiple second through holes disposed in a sidewall of the second tube. The first tube is mounted around the second tube. The first tube and the second tube have a gap therebetween, such that a gas is permitted to flow from the internal processing space through the multiple first through holes, the multiple second through holes, the space in the first tube, and the space in the second tube and flow to the gas collection channel.

Thus, in the plasma energization equipment according to the present invention, by the provision of the gas flow guiding device including the hollow first tube, the hollow second tube, the multiple first through holes, and the multiple second through holes, the gas in the furnace may be effectively guided to the gas collection channel, which is advantageous to guiding and discharge of the gas.

In an example, the first tube includes a first ratchet tooth. The second tube includes a second ratchet tooth. The first ratchet tooth meshes with the second ratchet tooth, such that when one of the first tube and the second tube rotates in a first direction about an axis, another of the first tube and the second tube is driven to rotate synchronously. When an external resistance imparted to the first tube is greater than a resistance between the first tube and the second tube, one of the first tube and the second tube rotates in a second direction about the axis, and another of the first tube and the second tube jumps along the axis. The first direction is one of a clockwise direction and a counterclockwise direction, and the second direction is another of the clockwise direction and the counterclockwise direction. Thus, the first tube may rotate or jump to stir ambient materials, particularly the materials in the elements or around the structure, such as in the first tube, the multiple first through holes, and the second multiple through holes in the second tube, thereby guiding the gas among the materials. Thus, the gas in the internal processing space may flow easily into the gas flow guiding device, thereby avoiding backdraft.

In an example, the first tube includes a first top end and a first bottom end opposite to the first top end along an axial direction. The second tube includes a second top end and a second bottom end opposite to the second top end along the axial direction. The first tube includes an axle. Each of the second top end and the second bottom end of the second tube has an axial hole. The axle extends through each axial hole. Thus, by extending the axle through two axial holes spaced from each other, stable connection relationship between the first tube and the second tube may be maintained while the first tube is moving relative to the second tube, particularly maintaining stable connection relationship between the first ratchet tooth and the second ratchet tooth.

In an example, the first tube has radial lengths in a radially outward direction which vary along the axial direction. Thus, when relative movement occurs between the first tube and the second tube, the ambient materials may be stirred more efficiently to guide the gas among the materials, such that the gas in the internal processing space may flow easily into the gas flow guiding device, thereby avoiding backdraft.

In an example, a portion of the second tube extends axially beyond the first tube to form a protruding portion. The protruding portion includes at least one of the multiple second through holes. The second tube includes a second top end and a second bottom end opposite to the second top end along an axial direction. The protruding portion includes increasing radial lengths toward the second bottom end along the axial direction to provide a gradually expanding shape. At least one of the multiple second through holes is disposed in a location of the protruding portion having a larger radial length. Thus, the gas flowing into the gas flow guiding device may flow more easily from the gas flow guiding device to the gas collection channel. Particularly, the gas in the second tube tends to flow radially outward, thereby efficiently collecting the gas and discharging the gas from inside of the furnace.

In an example, the first tube includes a first top end and a first bottom end opposite to the first top end along an axial direction. The first tube includes an opening formed in the first bottom end. The gradually expanding shape of the protruding portion is configured to permit the gas flowing out of the opening to flow radially outward along the gradually expanding shape and toward the gas collection channel. Thus, the gas in the first tube tends to flow radially outward, thereby efficiently collecting the gas and discharging the gas from inside of the furnace.

In an example, the plasma energization equipment further comprises a stirring device including a stirring member disposed in the internal processing space of the furnace. The stirring member includes a first fluid passageway and at least one first output passageway. The gas inputted to the first fluid passageway is permitted to be outputted via the at last one first output passageway. Thus, the materials may be scattered to avoid the materials from bridge formation effect while increasing the oxygen content of the materials.

In an example, the stirring member includes at least one stirring portion extending radially outward from the stirring member. Each stirring portion includes at least one second fluid passageway and at least one second output passageway. The at least one second fluid passageway intercommunicates with the first fluid passageway, such that the gas inputted into the first fluid passageway is permitted to flow into each second fluid passageway and then outputted via a corresponding second output passageway. Thus, the materials may be scattered to avoid the materials from bridge formation effect while increasing the oxygen content of the materials.

In an example, the plasma energization equipment further comprises a gas treatment system. The gas treatment system includes a temporary gas tank, a gas/liquid separator, a recovery unit, and a detection unit. The temporary gas tank is configured to receive the gas discharged from the gas collection channel of the furnace. The gas/liquid separator is configured to receive the gas discharged from the temporary gas tank and a waste liquid obtained from condensation of the gas. A liquid recovery device is disposed below the gas/liquid separator to receive the condensed waste liquid. The recovery unit receives the gas discharged from the gas/liquid separator and stores the received gas. The detection unit receives the gas discharged from the gas/liquid separator and detects the received gas. Thus, by the provision of the gas/liquid separator, the high-temperature gas discharged from the furnace may be cooled and the waste liquid may be obtained through condensation, thereby achieving the effect of separating the waste liquid from the gas. Furthermore, by the provision of the recovery unit, the discharged gas may be collected and reused. Furthermore, by the provision of the detection unit, the discharged gas may be detected to assure that the discharged gas meets the environmental protection regulations.

In an example, the gas/liquid separator includes a liquid cooling structure. The liquid cooling structure is provided with multiple intercommunicating pipes and at least one liquid passageway. Each of the multiple intercommunicating pipes is configured to permit flow of the gas in the gas/liquid separator. The at least one liquid passageway surrounds a portion or all of the multiple intercommunicating pipes. The at least one liquid passageway is configured to permit a liquid to flow into and out of the gas/liquid separator. Thus, by the provision of the liquid cooling structure, the liquid with a lower temperature in the at least one liquid passage will at least partially envelop the intercommunicating pipes containing a gas with a higher temperature, thereby enhancing the effect of cooling of the gas and condensation of the waste liquid.

In an example, the plasma energization equipment further comprises a cooling system including a liquid cooling module. The liquid cooling module includes a liquid storage tank, a liquid cooling portion, a cooler, and multiple liquid pipes. The liquid storage tank is configured to receive a liquid for cooling. The liquid cooling portion is disposed on the heating module to receive the liquid from the liquid storage tank and to cool the heating module. The cooler is configured to receive the liquid flowing through the liquid cooling portion to thereby cool the liquid which is then discharged to the liquid storage tank. The multiple liquid pipes are disposed between the liquid storage tank, the liquid cooling portion, and the cooler. Thus, by the provision of the liquid cooling module, the heating module may be cooled rapidly.

In an example, the plasma energization equipment further comprises a cooling system including a gas cooling module. The gas cooling module includes a gas supplier, a gas cooling portion, and multiple gas pipes. The gas supplier is configured to supply a gas into the gas cooling portion. The gas cooling portion is disposed on the heating module. The multiple gas pipes are disposed between the gas supplier and the gas cooling portion. Thus, by the provision of the gas cooling module, the heating module may be cooled rapidly.

### DESCRIPTION OF THE DRAWINGS

FIG. 1 is a diagrammatic cross sectional view illustrating a structure of a preferred embodiment of a plasma energization equipment according to the present invention.
FIG. 2 is an exploded, perspective view of a gas flow guiding device of the plasma energization equipment according to the present invention.
FIG. 3 is an enlarged view of a portion of the gas flow guiding device according to the present invention.
FIG. 4 is a cross sectional view of the structure of the gas flow guiding device according to the present invention.
FIG. 5 is an enlarged view of a circled portion A of FIG. 4.
FIG. 6 is a diagrammatic view illustrating disposition of the plasma energization equipment according to the present invention and a cooling system.
FIG. 7 is a cross sectional view of a liquid cooling structure of a gas treatment system according to the present invention.
FIG. 8 is a cross sectional view taken along section line A-A of FIG. 7.

### DETAILED DESCRIPTION OF THE INVENTION

In order to make the above and other objectives, features, and advantages of the present invention clearer and easier to understand, preferred embodiments of the present invention will be described hereinafter in connection with the accompanying drawings. Furthermore, the elements designated by the same reference numeral in various figures will be deemed as identical, and the description thereof will be omitted.

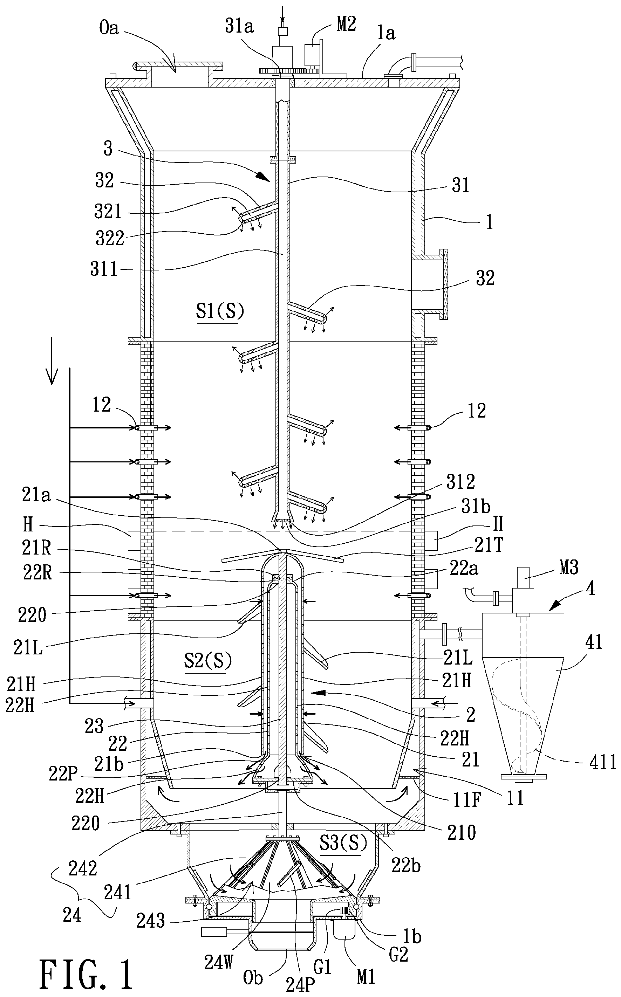

With reference to FIG. 1 showing a preferred embodiment of a plasma energization equipment according to the present invention, the plasma energization equipment comprises a furnace 1, a heating module **H**, a gas flow guiding device 2. The heating module **H** and the gas flow guiding device 2 are disposed in the furnace 1.

The furnace 1 includes an internal processing space **S**. Particularly, the furnace 1 is substantially in the form of a barrel to define the internal processing space **S**. Specifically, the internal processing space **S** is configured for stacking materials to be treated and includes a stockpiling area S1, a charcoal slag layer area S2, and an ash accumulation area S3 arranged axially from top to bottom. For example, the to-be-treated materials are waste materials, preferably biomass materials/waste. These materials will be heated in the charcoal slag layer area S2 and turn into treated materials, particularly ashes which are then discharged via the ash accumulation area S3.

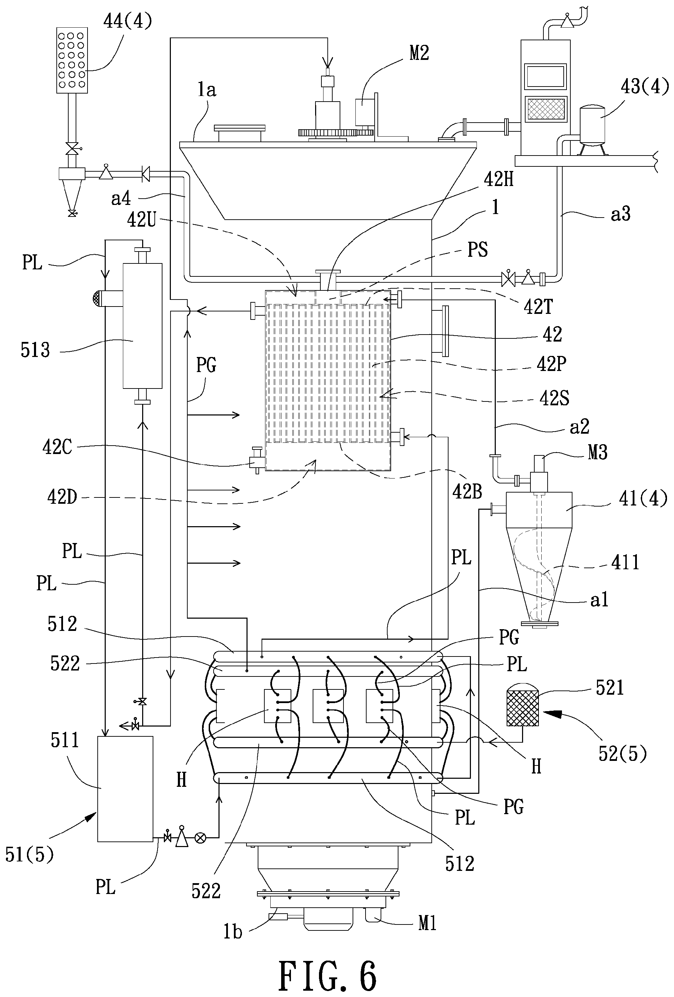

Particularly, the furnace 1 includes an interior having a gas collection channel 11 intercommunicating with the internal processing space **S**. Thus, the gas in the internal processing space **S** may be guided through the gas collection channel 11 into a gas treatment system 4 (as shown in FIG. 6, which will be set forth hereinafter). Optionally, a filtering mesh 11F is disposed in the gas collection channel 11 to filter ash in the gas flowing through the gas collection channel 11.

Specifically, the furnace 1 includes a furnace top end 1a and a furnace bottom end 1b opposite to the furnace top end 1a along an axial direction. A top end opening Oa is provided in the furnace top end 1a, such that the waste may be inputted via the top end opening Oa into the internal processing space **S** of the furnace 1. A bottom end opening Ob is provided in the furnace bottom end 1b, such that the treated waste (such as ash) in the internal processing space **S** may be discharged via the bottom end opening Ob.

Optionally, the furnace 1 includes multiple gas inlets 12 to permit supply of air or other combustion accelerants into the internal processing space **S**, thereby increasing the oxygen content in the materials in the furnace 1 or increasing the combustion efficiency.

The heating module **H** is disposed in the furnace 1 and is particularly disposed in a location aligned with the internal processing space **S** for heating the waste in the charcoal slag layer area S2. The heating module **H** may generate a temperature above 300°C at the charcoal slag layer area S2, preferably 400-1200°C, and more preferably 500-900°C. Nevertheless, the present invention is not limited to the temperate described in the examples, and the temperature may be adjusted by an unit of 1°C. Optionally, the heating module **H** may be a microwave equipment. Nevertheless, the present invention is not limited to this example. Particularly, the heating module **H** may be used together with a cooling system 5 (as shown in FIG. 6, which will be set forth hereinafter).

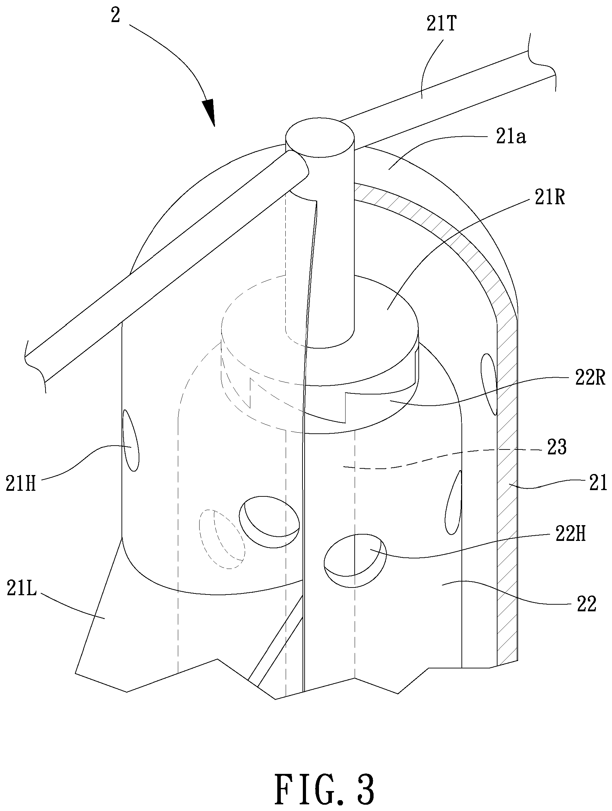

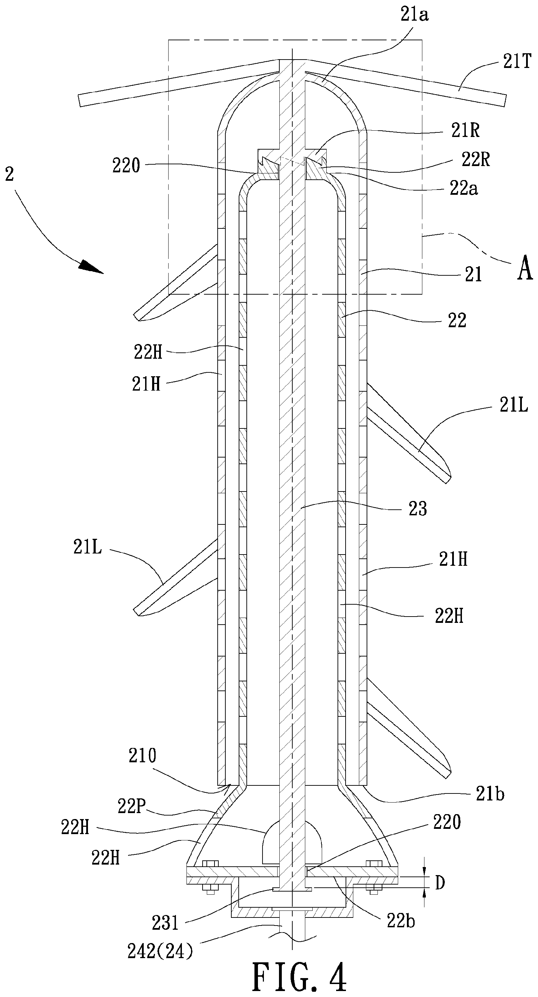

As shown in FIGS. 1-5, the gas flow guiding device 2 is disposed in the internal processing space **S** and extends from the charcoal slag layer area S2 toward the ash accumulation area S3. The gas flow guiding device 2 includes a first tube 21 and a second tube 22. The first tube 21 extends axially and is a hollow casing having a space therein. The first tube 21 includes multiple first through holes 21H disposed in a sidewall of the first tube 21. The second tube 22 extends axially and is a hollow casing having a space therein. The second tube 22 includes multiple second through holes 22H disposed in a sidewall of the second tube 22. The first tube 21 is mounted around the second tube 22. The first tube 21 and the second tube 22 have a gap therebetween, such that the gas may flow from the internal processing space S through the multiple first through holes 21H, the multiple second through holes 22H, the space in the first tube 21, and the space in the second tube 22. Preferably, the gas flows out of at least one second through hole 22H of the second tube 22 distant to the first tube 21 in the axial direction and then flows into the gas collection channel 11.

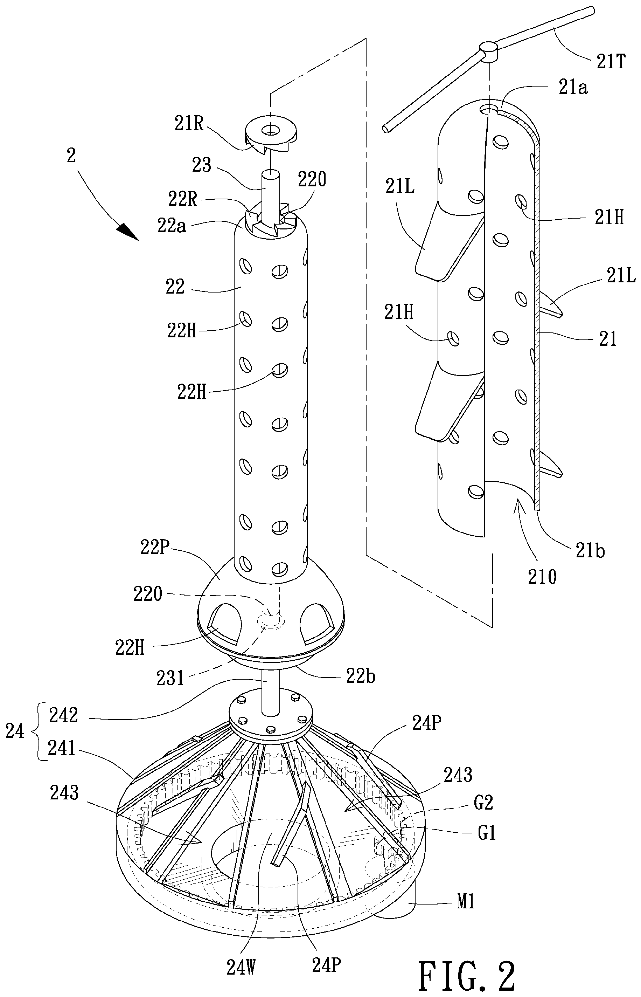

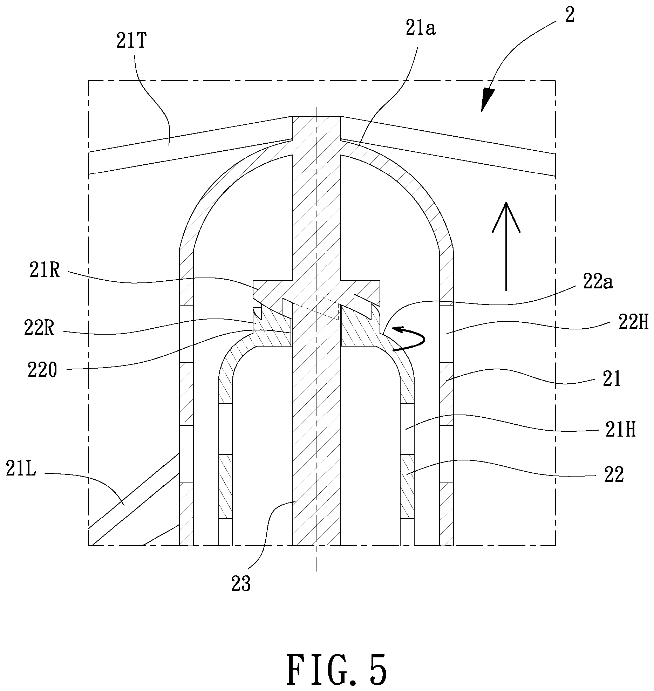

Particularly, as shown in FIGS. 2-5, the first tube 21 includes a first ratchet tooth 21R, and the second tube 2 includes a second ratchet tooth 22R. The first ratchet tooth 21R meshes with the second ratchet tooth 22R, such that when one of the first tube 21 and the second tube 22 rotates in a first direction about an axis, another of the first tube 21 and the second tube 22 is driven to rotate synchronously. Particularly, as shown in FIG. 5, when an external resistance imparted to the first tube 21 is greater than a resistance between the first tube 21 and the second tube 22, one of the first tube 21 and the second tube 22 rotates in a second direction about the axis, and another of the first tube 21 and the second tube 22 jumps or reciprocates along the axis. The first direction is one of a clockwise direction and a counterclockwise direction, and the second direction is another of the clockwise direction and the counterclockwise direction.

It should be noted that in a practical application involving rotation in the second direction, to-be-treated materials are placed into the internal processing space S, such that the first tube 21 is subjected to an external resistance from the materials, which will be substantially greater than the resistance (static friction) between the first ratchet tooth 21R and the second ratchet tooth 22R. Thus, a jumping motion will occur between the first tube 21 and the second tube 22. Particularly, given that the second tube 22 will not displace in the axial direction, the jumping motion will enable the first tube 21 to stir the ambient materials, such that the gas in the internal processing space **S** may flow easily into the gas flow guiding device 2.

Specifically, in an example illustrated in FIGS. 1-5, the first tube 21 includes a first top end 21a and a first bottom end 21b opposite to the first top end 21a along an axial direction. The first tube 21 extends from the first top end 21a toward the first bottom end 21b and forms an opening 210 in the first bottom end 21b. The second tube 22 is mounted in the first tube 21 via the opening 210.

Particularly and optionally, the first tube 21 may be disposed to include radial lengths varying along the axial direction. Thus, when the first tube 21 rotates, the materials on the radial side may be pushed to avoid the materials from bridge formation effect, and the materials may be loosened to enable the gas in the internal processing space **S** to flow into the gas flow guiding device 2. The arrangement of the varying radial lengths of the first tube 21 along the axial direction may be achieved by disposition of corresponding stirring members. Optionally, the first tube 21 includes a top portion stirring member 21T extending radially outward from the first top end 21a for pushing the materials on the radial side. Optionally, the first tube 21 includes one or more sidewall stirring members 21L extending radially outward from the sidewall of the first tube 21. Optionally, when multiple sidewall stirring members 21L are used, the multiple sidewall stirring members 21L are arranged to be spaced from each other in the axial direction and/or the radial direction, thereby providing a better pushing effect for the materials on the radial side.

Specifically, in an example of the present invention illustrated in FIGS. 1-5, the second tube 22 includes a second top end 22a and a second bottom end 22b opposite to the second top end 22a along the axial direction. The second tube 22 extends from the second top end 22a toward the second bottom end 22b. The second ratchet tooth 22R is provided on an outer wall of the second top end 22a of the second tube 22. When the first tube 21 is mounted around the second tube 22, the first ratchet tooth 21R meshes with the second ratchet tooth 22R to achieve synchronous rotation or relative jumping motion between the first tube 21 and the second tube 22.

Preferably, a portion of the second tube 22 extends axially beyond the first tube 21 to form a protruding portion 22P. The protruding portion 22P includes at least one of the multiple second through holes 22H, preferably plural second through holes 22H. Thus, by the provision of the protruding portion 22P protruding axially beyond the first tube 21, the gas flowing into the gas flow guiding device 2 may flow more easily from the gas flow guiding device 2 into the gas collection channel 11.

Preferably, the protruding portion 22P includes increasing radial lengths toward the second bottom end 22b along the axial direction to provide a gradually expanding shape. At least one of the multiple second through holes 22H is disposed in a location of the protruding portion 22P having a larger radial length. Thus, by the provision of at least one second through hole 22H disposed in a location of the protruding portion 22P having a larger radial length, the gas in the second tube 22 tends to flow radially outward. Therefore, the location where the gas flows outward is more adjacent to the gas collection channel 11, and the gas flows toward the gas collection channel 11, which assists the gas in flowing into the gas collection channel 11. Particularly, the gradually expanding shape of the protruding portion 22P enables the gas flowing out of the opening 210 at the first bottom end 21b of the first tube 21 to flow radially outward along the gradually expanding shape of the protruding portion 22P, such that the gas flows toward the gas collection channel 11, which assists the gas in flowing into the gas collection channel 11.

Preferably, to stabilize the meshing relationship between the first ratchet tooth 21R and the second ratchet tooth 22R, the first tube 21 may further include an axle 23. Each of the second top end 22a and the second bottom end 22b of the second tube 22 has an axial hole 220. The axle 23 extends through each axial hole 220. Thus, by the axial holes 220 having a specific distance along the axial direction, movement of the axle 23 in the radial direction is restricted by the axial holes 220 to maintain the connection relationship between the first ratchet tooth 21R and the second ratchet tooth 22R while the first tube 21 is rotating or jumping. Specifically, to install the axle 23, the first ratchet tooth 21R and the second ratchet tooth 22R have corresponding axial holes 210, 220 through which the axle 23 extends. Furthermore, the first tube 21 may optionally include a corresponding axial hole 210 to permit insertion of the axle 23. Preferably, the axle 23 includes an enlarged portion 231 on an end thereof extending beyond the second bottom end 22b via the axial hole 220. A radial length of the enlarged portion 231 is greater than a radial length of the axial hole 220 to avoid the axle 23 from disengaging from the axial hole 220 of the second bottom end 22b, thereby maintaining the connection relationship between the first ratchet tooth 21R and the second ratchet tooth 22R while avoiding skew between the first ratchet tooth 21R and the second ratchet tooth 22R. Particularly, the enlarged portion 231 and the second bottom end 22b have a spacing D therebetween along the axial direction. The spacing D is not smaller than the jumping distance of the first ratchet tooth 21R relative to the second ratchet tooth 22R along the axial direction.

Particularly, the gas flow guiding device 2 includes a first driving member M1 to drive the first tube 21 and the second tube 22 to rotate or jump. In an example illustrated in FIGS. 1-5, the gas flow guiding device 2 further includes a bottom extension 24 mounted to the second bottom end 22b of the second tube 22. The bottom extension 24 is connected to the first driving member M1 to enable the first driving member M1 to drive the bottom extension 24 and the second tube 22 to rotate. Furthermore, by controlling the first driving member M1 to rotate in the forward direction or reverse direction, the first tube 21 and the second tube 22 can be driven to rotate synchronously or undergo relative jumping motion. Particularly, in this example, the first driving member M1 may be a motor including an output shaft with a first gear G1 having a specific gear ratio with respect to a second gear G2 mounted to the bottom extension 24. Furthermore, the first gear G1 has external gear teeth, and the second gear G2 has internal gear teeth. Nevertheless, it should be noted that the bottom extension 24, the first gear G1 and the second gear G2 shown in FIGS. 1-5 are merely used to achieve the motion mechanism of the gas flow guiding device 2. Various dispositions and motion relationships of various elements may be included based on the motion mechanism of the gas flow guiding device 2 according to the present invention.

Preferably, the bottom extension 24 includes a bottom member 241 and an optional extension 242. The radial length of the bottom member 241 increases gradually from the second bottom end 2b toward the furnace bottom end 1b. The bottom member 241 includes multiple bottom walls 24W alternatingly disposed with respect to multiple bottom openings 243. Each bottom wall 24W includes a radial protruding portion 24P for pushing ambient material (such as ash) when the bottom extension 24 rotates, thereby guiding the material from the bottom opening 243 to be discharged via the bottom end opening Ob of the furnace 1. The extension 242 is connected to the second tube 22 and the bottom member 241. Particularly, the extension 242 has a proper length to enable the bottom member 241 and the second tube 22 to be disposed in a proper location of the furnace 1.

Optionally, as shown in FIG. 1, the plasma energization equipment according to the present invention may further comprise a stirring device 3. The stirring device 3 includes a stirring member 31 disposed in the internal processing space **S** and preferably axially extending in the stockpiling area S1. Furthermore, the stirring member 31 includes a first fluid passageway 311 and at least one first output passageway 312, both of which are hollow. Thus, the gas inputted to the first fluid passageway 311 is permitted to be outputted via the at last one first output passageway 312. In an example, the stirring member 31 includes a first end 31a and a second end 31b opposite to the first end 31a. The first end 31a is adjacent to the furnace top end 1a. The second end 31b is distant to the furnace top end 1a. The at least one first output passageway 312 is disposed on the second end 31b of the stirring member 31. Particularly, the stirring device 3 may further include a second driving member M2 for driving the stirring member 31 to rotate. In an example illustrated in FIG. 1 according to the present invention, the first end 31a protrudes beyond the furnace top end 1a and may be driven by the second driving member M2 mounted outside of the furnace top end 1a, thereby rotating the stirring member 31.

Preferably, the stirring member 31 includes at least one stirring portion 32 extending radially outward from the stirring member 31. Particularly, when the stirring member 31 includes multiple stirring portions 32, the multiple stirring portions 32 are disposed to be spaced from each other along the axial direction or the radial direction. Preferably, each stirring portion 32 includes at least one second fluid passageway 321 and at least one second output passageway 322, both of which are hollow. The at least one second fluid passageway 321 intercommunicates with the first fluid passageway 311, such that the gas inputted into the first fluid passageway 311 is permitted to flow into each second fluid passageway 321 and then outputted via a corresponding second output passageway 322. Particularly, when a stirring portion 32 includes multiple second output passageways 322, the passage directions of the multiple second output passageways 322 may be arranged in any desired manner. Preferably, a portion of the multiple second output passageways 322 faces downward, such as toward the furnace bottom end 1b, whereas another portion of the multiple second output passageways 322 faces upward, such as toward the furnace top end 1a.

By the provision of the first fluid passageway 311 and the first output passageway 312 of the stirring member 31 and preferred cooperation with the second fluid passageway 321 and the second output passageway 322 of the stirring portion 32, when the outputted gas ejects from the first output passageway 312 and the second output passageway 322, the ejected currents may stir ambient materials in the internal processing space **S**, thereby scattering the materials and avoiding bridge formation effect of the materials while assisting in an increase in the oxygen content in the materials. Furthermore, by the disposition of each stirring portion 32 extending radially outward from the stirring member 31, when the stirring member 31 rotates about the axis, each stirring portion 32 may scatter the materials and avoid bridge formation effect of the materials

Optionally, as shown in FIGS. 1 and 6, the plasma energization equipment according to the present invention may further comprise a gas treatment system 4. The gas treatment system 4 may include a temporary gas tank 41, a gas/liquid separator 42, a recovery unit 43, and a detection unit 44. The temporary gas tank 41 is configured to receive the gas (namely, high-temperature exhaust gas) discharged from the furnace 1. Particularly, the gas collected by the gas collection channel 11 may flow into the temporary gas tank 41 via a first gas channel a1. Specifically, the temporary gas tank 41 has a hollow tank therein and may include a scraping board 411 rotatably mounted in the temporary gas tank 41. Preferably, the shape of the scraping board 411 corresponds to a contour of an inner wall of the hollow tank of the temporary gas tank 41, and a third driving member M3 is used to drive the scraping board 411 to rotate, thereby scraping ash or particulates (in the received gas) from the inner wall of the temporary gas tank 41.

The gas/liquid separator 42 is configured to receive the gas discharged from the temporary gas tank 41 and to receive a waste liquid obtained from condensation of the gas. Particularly, the gas discharged from the temporary gas tank 41 may flow into the gas/liquid separator 42 via a second gas channel a2. Specifically, the gas/liquid separator 42 may further include a liquid recovery device 42C. The liquid recovery device 42C is disposed below the gas/liquid separator 42 to receive the condensed waste liquid. The condensed waste liquid may but not limited to include a by-product liquid including tar.

The recovery unit 43 and the detection unit 44 are configured to receive the gas discharged from the gas/liquid separator 42, particularly the gas whose temperature is lowered and the condensed waste liquid has been removed from the gas. The gas may flow to the recovery unit 43 via a third gas channel a3 and may flow to the detection unit 44 via a fourth gas channel a4. In an example, the recovery unit 43 may be a gas storage device to store/collect the received gas, particularly in a high pressure approach. Preferably, the recovery unit 43 may recover synthetic gas containing carbon monoxide (CO), hydrogen (H₂), and methane (CH₄). The detection unit 44 may include a gas filtration module to filter the received gas before discharging into the environment to assure that the discharged gas meets the quality required by the environmental protection regulations. The detection unit 44 may detect the gas to be discharged to assure that the discharged gas meets the quality required by the environmental protection regulations.

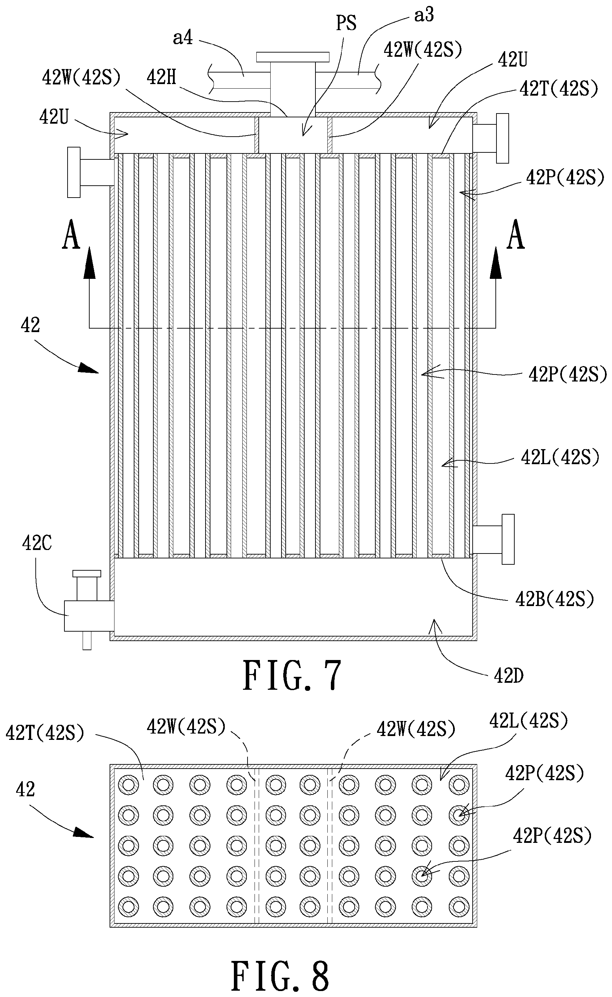

Particularly, as shown in FIGS. 6-8 according to the present invention, the gas/liquid separator 42 includes a liquid cooling structure 42S. The liquid cooling structure 42S is provided with multiple intercommunicating pipes 42P and at least one liquid passageway 42L. Each of the multiple intercommunicating pipes 42P is configured to permit flow of the gas in the gas/liquid separator 42. The at least one liquid passageway 42L surrounds a portion or all of the multiple intercommunicating pipes 42P. The at least one liquid passageway 42L is configured to permit a liquid to flow into and out of the gas/liquid separator 42. Thus, by the disposition of the liquid cooling structure 42S, the liquid flowing through the liquid passageway 42L has a lower temperature and at least partially envelops the multiple intercommunicating pipes 42P containing a gas with a higher temperature, thereby assisting in lowering the temperature of the gas and condensation of the waste liquid.

It should be noted that FIG. 6 may be used to illustrate the relative system disposition suitable for the furnace 1 shown in FIG. 1. The positions of some of the elements shown in FIG. 6 are slightly different from those shown in FIG. 1. Nevertheless, the differences are based on the relative position of the elements without adversely affecting achievement of the concrete technical content of the present invention and should be appreciated by one having ordinary skill in the art of the invention.

Specifically, the liquid cooling structure 42S includes a top wall 42T and a bottom wall 42B to divide the interior of the liquid cooling structure 42S into an upper space 42U and a lower space 42D. Furthermore, at least one partitioning wall 42W is disposed around an intercommunicating port 42H (where the third gas channel a3 and/or the fourth gas channel a4 intercommunicate with the gas/liquid separator 42, particularly the upper space 42U) and extends to the top wall 42T. A passage space PS is defined between the at least one partitioning wall 42W, the top wall 42T, and the gas/liquid separator 42. The passage space PS does not directly intercommunicate with the upper space 42U. Furthermore, the gas in the gas/liquid separator 42 flows through the upper space 42U and passes through a portion of the multiple intercommunicating pipes 42P and the lower space 42D and then flows through the intercommunicating pipe 42P aligned and intercommunicating with the passage space PS and finally through the passage space PS, thereby discharging the gas to the recovery unit 43 or the detection unit 44.

Optionally, referring to FIG. 6 again, the plasma energization equipment according to the present invention may further comprises a cooling system 5. The cooling system 5 may be used to cool the heating module **H** and also may be used to cool the high-temperature gas. The cooling system 5 includes a liquid cooling module 51 and an optional gas cooling module 52. The liquid cooling module 51 includes a liquid storage tank 511, a liquid cooling portion 512, a cooler 513, and multiple liquid pipes PL. The multiple liquid pipes PL are configured to guide a liquid to flow into associated elements. The liquid storage tank 511 is configured to receive a liquid for cooling. The liquid cooling portion 512 is disposed on the heating module **H**, particularly around the heating module **H**, to receive the liquid from the liquid storage tank 511 and to cool the heating module **H**. It should be noted that although two liquid cooling portions 512 are illustrated in FIG. 6, the quantity of the liquid cooling portions 512 may be one or more according to the practical situation in use. The present invention is not limited to the structure shown in the figures. The cooler 513 is configured to cool the liquid which is then discharged to the liquid storage tank 511 and is configured to at least receive the liquid flowing through the liquid cooling portions 512.

Preferably, the fluid flowing through the liquid cooling portions 512 may be guided by associated liquid pipes PL to the liquid passageways 42L in the liquid cooling structure 42S of the gas/liquid separator 42, such that the high-temperature gas discharged from the furnace 1 may be cooled more efficiently. Then, the liquid flows into the cooler 513. In this case, the multiple liquid pipes PL are correspondingly disposed between the liquid storage tank 511, the liquid cooling portions 512, and the cooler 513. In an alternative embodiment (not shown), the liquid in the liquid cooling structure 42S may be inputted from the liquid storage tank 511 via other liquid pipes PL.

Optionally, the gas cooling module 52 includes a gas supplier 521, a gas cooling portion 522, and multiple gas pipes PG. The multiple gas pipes PG are configured to guide a gas to flow to associated elements. The gas supplier 521 is configured to supply the gas into the gas cooling portion 522, such as a gas pump or a high-pressure air tank and preferably includes an air filter to filter the gas supplied. The gas supplier 521 may supply the gas into the gas cooling portion 522 via corresponding gas pipes PG. Optionally, the gas may be supplied from the corresponding gas pipes PG into the furnace 1 having multiple gas inlets 12 and/or the stirring member 31. Thus, by the disposition of the gas cooling portion 522, the heating module **H** may be cooled rapidly. Furthermore, by the disposition of the gas pipes PG capable of supplying the gas to the furnace 1, preheating of the to-be-treated materials in the furnace 1 may be conducted easily. Optionally, the plasma energization equipment according to the present invention may provide a gas required by the furnace 1 and the stirring member 31 through different gas supping devices. The gas cooling portion 522 is disposed on the heating module **H**, particularly around the heating module **H**, to receive the gas from the gas supplier 521 for cooling the heating module **H**. It should be noted that although two gas cooling portions 522 are shown in FIG. 6, the quantity of the gas cooling portions 522 may be one or more according to the practical situation in use. The present invention is not limited to the structure shown in the figures.

A pattern of the operating mechanism of the plasma energization equipment will be set forth based on the disposition of the elements of the plasma energization equipment according to the present invention described above. The heating module **H** may be used to heat the materials in the charcoal slag layer area S2 to preheat the charcoal slag layer generated in the furnace 1. As an example, an ordinary production method of a charcoal slag layer generally includes two procedures. In the first procedure, corresponding organic substances are heated and then dried at a temperature of 170-600°C. About 80% of the organic substances are carbonized to achieve preliminary dehydration and carbonization. In the second procedure, after the preliminary dehydration and carbonization in the first procedure, a chemical method or a physical method is carried out to provide the organic substances with a suitable shape to serve as a charcoal raw material, which is placed into the furnace 1, and suitable temperature and pressure are set. In a state in which a gas is supplied, the charcoal raw material is heated to accomplish activation of the charcoal raw material. One of the physical methods for activation may be accomplished by reaction with activators, such as steam and charcoal.

For example, when the furnace 1 according to the present invention is used for the first time, agricultural wastes, including, e.g., rice husks, wood, coconut shells, sawdust, coal, coke, peat, lignin, cores, hard nut shells, sucrose pulp, bones, brown coal, and petroleum residue, preferably coal and coconut shells, are piled in the charcoal slag layer area S2 and the ash accumulation layer S3 and are heated in a condition without oxygen or with extremely little oxygen. When the combustion temperature in the ash accumulation layer S3 reaches 500-900°C, a corresponding combustion process is conducted on the materials in the charcoal slag layer area S2 to form a charcoal slag layer according to the present invention. After formation of the charcoal slag layer area S2, to-be-treated materials (particularly biomass waste) are added into the furnace 1 and piled in the stockpiling area S1 (namely above the charcoal slag layer area S2). The added materials are heated by the high temperature produced by the charcoal slag layer and turn into pyrolyzed gases after pyrolysis. The pyrolyzed gases under high temperature will cause acceleration of delocalized electrons in the gases to impact neutral particles in the gases, which turns the electrons and the atomic nucleus of the neutral particles into delocalized electrons, thereby ionizing the respective gases. Particularly, the gases turn into plasma after ionization. The high-energy electrons generated by the discharging of the plasma have a higher energy sufficient to cause breakage or lysis of the chemical bonds in local specific locations of most common pollutant molecules. These gases generated during the heating process will be preliminarily filtered by the respective charcoal slag layer and then undergo composite chemical reactions with the elements generated by the lysis of the charcoal slag layer. Then, these gases are guided by the gas flow guiding device 2 to the gas collection channel 11 and the gas treatment system 4. Thus, damage to the furnace 1 by the harmful substances in the high-temperature exhaust gas may be prevented to prolong the service life of the furnace 1.

It should be noted that delivery of the liquid and the gases between the elements according to the present invention may be achieved by elements provided with corresponding pipelines, pump devices, and control valves, which can be appreciated by one having ordinary skill in the art and, thus, will not be set forth to avoid redundancy.

In summary, in the plasma energization equipment according to the present invention, by the provision of the gas flow guiding device 2 including the disposition of the first tube 21, the second tube 22, and the multiple through holes 21H, 22H, the gas in the gas flow guiding device 2 may be effectively guided to the gas collection channel 11, which is advantageous to guiding and discharge of the gas. Furthermore, by the provision of the first ratchet tooth 21R and the second ratchet tooth 22R respectively on the first tube 21 and the second tube 22, the first tube 21 may rotate or jump to stir ambient materials, such that the gas in the internal processing space S may flow easily into the gas flow guiding device 2. Furthermore, by the provision of the protruding portion 22P of the second tube 22 extending axially beyond the first tube 21, and, particularly, the protruding portion 22P has a gradually expanding shape, such that the gas may flow to the gas collection channel 11 more easily. Furthermore, by the provision of the first tube 21 including the axle 23, or by the provision of the enlarged portion 231 having a radial length greater than the redial length of the axial hole 220, a stable connection relationship between the first tube 21 and the second tube 22 may be maintained while the first tube 21 is moving relative to the second tube 22, particularly maintaining the stable connection relationship between the first ratchet tooth 21R and the second ratchet tooth 22R.

Although the present invention has been described with respect to the above preferred embodiments, these embodiments are not intended to restrict the present invention. Various changes and modifications on the above embodiments made by any person skilled in the art without departing from the spirit and scope of the present invention are still within the technical category protected by the present invention. Accordingly, the scope of the present invention shall include the literal meaning set forth in the appended claims and all changes which come within the range of equivalency of the claims. Furthermore, in a case that several of the above embodiments can be combined, the present invention includes the implementation of any combination.

## Claims

1. A plasma energization equipment comprising:
a furnace (1) including an internal processing space (S) and a gas collection channel (11) intercommunicating with the internal processing space (S);
a heating module (H) disposed in the furnace (1) to heat the internal processing space (S); and
a gas flow guiding device (2) disposed in the internal processing space (S) and including:
a first tube (21) which extends axially and is a hollow casing having a space therein, wherein the first tube (21) includes multiple first through holes (21H) disposed in a sidewall of the first tube (21); and
a second tube (22) which extends axially and is a hollow casing having a space therein, wherein the second tube (22) includes multiple second through holes (22H) disposed in a sidewall of the second tube (22),
wherein the first tube (21) is mounted around the second tube (22), wherein the first tube (21) and the second tube (22) have a gap therebetween, such that a gas is permitted to flow from the internal processing space (S) through the multiple first through holes (21H), the multiple second through holes (22H), the space in the first tube (21), and the space in the second tube (22) and flow to the gas collection channel (11).

2. The plasma energization equipment as claimed in claim 1, wherein the first tube (21) includes a first ratchet tooth (21R), wherein the second tube (22) includes a second ratchet tooth (22R), wherein the first ratchet tooth (21R) meshes with the second ratchet tooth (22R), such that when one of the first tube (21) and the second tube (22) rotates in a first direction about an axis, another of the first tube (21) and the second tube (22) is driven to rotate synchronously,
wherein when an external resistance imparted to the first tube (21) is greater than a resistance between the first tube (21) and the second tube (22), one of the first tube (21) and the second tube (22) rotates in a second direction about the axis, and another of the first tube (21) and the second tube (22) jumps along the axis,
wherein the first direction is one of a clockwise direction and a counterclockwise direction, and the second direction is another of the clockwise direction and the counterclockwise direction.

3. The plasma energization equipment as claimed in claim 1 or 2, wherein the first tube (21) includes a first top end (21a) and a first bottom end (21b) opposite to the first top end (21a) along an axial direction, wherein the second tube (22) includes a second top end (22a) and a second bottom end (22b) opposite to the second top end (22a) along the axial direction, wherein the first tube (21) includes an axle (23), wherein each of the second top end (22a) and the second bottom end (22b) of the second tube (22) has an axial hole (220), and wherein the axle (23) extends through each axial hole (220).

4. The plasma energization equipment as claimed in claim 1 or 2, wherein the first tube (21) has radial lengths in a radially outward direction which vary along the axial direction.

5. The plasma energization equipment as claimed in claim 1 or 2, wherein a portion of the second tube (22) extends axially beyond the first tube (21) to form a protruding portion (22P), wherein the protruding portion (22P) includes at least one of the multiple second through holes (22H), wherein the second tube (22) includes a second top end (22a) and a second bottom end (22b) opposite to the second top end (22a) along an axial direction, wherein the protruding portion (22P) includes increasing radial lengths toward the second bottom end (22b) along the axial direction to provide a gradually expanding shape, and wherein at least one of the multiple second through holes (22H) is disposed in a location of the protruding portion (22P) having a larger radial length.

6. The plasma energization equipment as claimed in claim 5, wherein the first tube (21) includes a first top end (21a) and a first bottom end (21b) opposite to the first top end (21a) along an axial direction, wherein the first tube (21) includes an opening (210) formed in the first bottom end (21b), wherein the gradually expanding shape of the protruding portion (22P) is configured to permit the gas flowing out of the opening (210) to flow radially outward along the gradually expanding shape and toward the gas collection channel (11).

7. The plasma energization equipment as claimed in claim 1 or 2, further comprising a stirring device (3) including a stirring member (31) disposed in the internal processing space (S) of the furnace (1), wherein the stirring member (31) includes a first fluid passageway (311) and at least one first output passageway (312), and wherein the gas inputted to the first fluid passageway (311) is permitted to be outputted via the at last one first output passageway (312).

8. The plasma energization equipment as claimed in claim 7, wherein the stirring member (31) includes at least one stirring portion (32) extending radially outward from the stirring member (31), wherein each stirring portion (32) includes at least one second fluid passageway (321) and at least one second output passageway (322), wherein the at least one second fluid passageway (321) intercommunicates with the first fluid passageway (311), such that the gas inputted into the first fluid passageway (311) is permitted to flow into each second fluid passageway (321) and then outputted via a corresponding second output passageway (322).

9. The plasma energization equipment as claimed in claim 1 or 2, further comprising a gas treatment system (4), wherein the gas treatment system (4) includes a temporary gas tank (41), a gas/liquid separator (42), a recovery unit (43), and a detection unit (44), wherein the temporary gas tank (41) is configured to receive the gas discharged from the gas collection channel (11) of the furnace (1), wherein the gas/liquid separator (42) is configured to receive the gas discharged from the temporary gas tank (41) and a waste liquid obtained from condensation of the gas, wherein a liquid recovery device (42C) is disposed below the gas/liquid separator (42) to receive the condensed waste liquid, wherein the recovery unit (43) receives the gas discharged from the gas/liquid separator (42) and stores the received gas, and wherein the detection unit (44) receives the gas discharged from the gas/liquid separator (42) and detects the received gas.

10. The plasma energization equipment as claimed in claim 9, wherein the gas/liquid separator (42) includes a liquid cooling structure (42S), wherein the liquid cooling structure (42S) is provided with multiple intercommunicating pipes (42P) and at least one liquid passageway (42L), wherein each of the multiple intercommunicating pipes (42P) is configured to permit flow of the gas in the gas/liquid separator (42), wherein the at least one liquid passageway (42L) surrounds a portion or all of the multiple intercommunicating pipes (42P), and wherein the at least one liquid passageway (42L) is configured to permit a liquid to flow into and out of the gas/liquid separator (42).

11. The plasma energization equipment as claimed in claim 1 or 2, further comprising a cooling system (5) including a liquid cooling module (51), wherein the liquid cooling module (51) includes a liquid storage tank (511), a liquid cooling portion (512), a cooler (513), and multiple liquid pipes (PL), wherein the liquid storage tank (511) is configured to receive a liquid for cooling, wherein the liquid cooling portion (512) is disposed on the heating module (H) to receive the liquid from the liquid storage tank (511) and to cool the heating module (H), wherein the cooler (513) is configured to receive the liquid flowing through the liquid cooling portion (512) to thereby cool the liquid which is then discharged to the liquid storage tank (511), wherein the multiple liquid pipes (PL) are disposed between the liquid storage tank 5(11), the liquid cooling portion (512), and the cooler (513).

12. The plasma energization equipment as claimed in claim 1 or 2, further comprising a cooling system (5) including a gas cooling module (52), wherein the gas cooling module (52) includes a gas supplier (521), a gas cooling portion (522), and multiple gas pipes (PG), wherein the gas supplier (521) is configured to supply a gas into the gas cooling portion (522), wherein the gas cooling portion (522) is disposed on the heating module (H), and wherein the multiple gas pipes (PG) are disposed between the gas supplier (521) and the gas cooling portion (522).
